# FASCICULE DE BREVET EUROPEEN

(11) **EP 1 353 381 B1**
(45) Date de publication et mention de la délivrance du brevet: **31.10.2007**
(21) Numéro de dépôt: 03100971.5
(22) Date de dépôt: 10.04.2003
(51) Int. Cl.: H01L 27/146, H01L 31/02

(54) **Matrice de photodetecteurs, à pixels isolés et grillé de stockage, hybridee sur un circuit de lecture**
Hybride Photodetektoranordnung mit isolierten Photogate-Bildelementen
Hybrid photodetector array with isolated photogate-type pixels

(30) Priorité: 12.04.2002 FR 0204614
(43) Date de publication de la demande: 15.10.2003
(73) Titulaire: COMMISSARIAT A L'ENERGIE ATOMIQUE, 75015 Paris (FR)
(72) Inventeur: Gidon, Pierre, 38130, Echirolles (FR); Pantigny, Philippe, 38640, Claix (FR)
(74) Mandataire: Poulin, Gérard

(56) Documents cités:
- EP-A- 0 820 104
- JP-A- 2001 339 057
- US-A- 4 684 812

## Description

### DOMAINE TECHNIQUE

L'invention concerne une matrice de photodétecteurs, à pixels isolés et photogrille, hybridée sur un circuit de lecture.

Les matrices de détecteurs ont le plus souvent pour but de retranscrire des images. Elles peuvent aussi être utilisées pour des signaux lumineux issus d'appareils de mesure. Le spectre lumineux qu'elles traitent peut aller de l'infrarouge à l'ultraviolet. Elles délivrent des signaux électriques en rapport avec les intensités lumineuses reçues. Certaines délivrent plusieurs signaux en parallèle, soit pour transmettre l'information plus rapidement, soit pour séparer les signaux issus de filtres de couleurs (donc de longueurs d'onde) différents.

### ETAT DE LA TECHNIQUE ANTERIEURE

Il existe de multiples structures de matrices de photodétecteurs.

Certaines structures possèdent des sites photosensibles et des amplificateurs des signaux délivrés par les sites disposés côte à côte. Des grilles de stockage de charges (photogrilles) peuvent être utilisées pour ces structures. En changeant le potentiel de la grille, les charges sont injectées ensemble vers les amplificateurs.

D'autres structures ont les sites photosensibles situés en vis-à-vis des amplificateurs afin de ne pas perdre de surface pour collecter la lumière. La matrice de photodétecteurs est alors hybridée au circuit de lecture comprenant les amplificateurs. La collecte des photoélectrons est effectuée par de simples photodiodes. Il n'est pas employé de grille de stockage. Il n'est pas connu de structure à photogrille (telle que les CCD) qui isole les pixels les uns des autres, ce qui fait que des charges indésirables arrivent dans les pixels adjacents.

Le document JP 2001-339057 A divulgue un procédé de fabrication d'un processeur d'images à trois dimensions comprenant une étape de collage, au moyen d'un adhésif, d'une plaque de verre pourvue de lentilles et d'une carte de conversion photoélectrique. La plaque est constituée de pixels, chaque pixel constituant un photodétecteur comprenant un plot de connexion à un circuit de traitement.

### EXPOSÉ DE L'INVENTION

L'invention propose une structure comprenant une matrice de photodétecteurs dont la surface est entièrement réservée à la collecte de la lumière et pour laquelle la détection fonctionne avec une grille capacitive de stockage de charges électriques (appelée photogrille). Une telle structure présente aussi la particularité de séparer électriquement les photodétecteurs grâce aux murs diélectriques de la photogrille. On obtient une structure de photodétection par hybridation de la matrice de photodétecteurs à grille et base commune sur un circuit d'amplificateurs.

L'invention a donc pour objet une matrice de photodétecteurs destinée à être hybridée sur un circuit de lecture et constituée à partir d'une plaque de matériau semiconducteur présentant une face de réception d'une lumière à détecter et une face opposée dite face d'hybridation, caractérisée en ce que la plaque est divisée en pixels, chaque pixel constituant un photodétecteur, les pixels étant séparés les uns des autres par des moyens de séparation formés transversalement dans la plaque et comprenant une photogrille pour les photodétecteurs, chaque photodétecteur présentant, sur la face d'hybridation, un plot de connexion permettant d'hybrider la matrice de photodétecteurs au circuit de lecture.

Selon un premier mode de réalisation, les moyens de séparation comprennent par des murs comprenant une paroi électriquement conductrice prise en sandwich entre des parois électriquement isolantes, constituant ainsi avec le matériau semiconducteur de la plaque adjacent au mur une photogrille de type MOS, chaque photodétecteur comprenant une première zone dopée et une deuxième zone dopée, les premières zones dopées assurant les prises de contact électrique avec les plots de connexion des photodétecteurs, les deuxièmes zones dopées assurant les prises de contact électrique avec une première électrode commune, dite électrode de base commune des pixels, située sur la face d'hybridation, les parois électriquement conductrices des murs étant reliées à une deuxième électrode commune située sur la face d'hybridation.

Avantageusement, la première électrode commune et la deuxième électrode commune forment des peignes interdigités.

Si le matériau semiconducteur est en silicium, la paroi électriquement conductrice des murs peut être en polysilicium dopé et les parois électriquement isolantes des murs peuvent être en oxyde de silicium.

Selon une variante de réalisation, les premières zones dopées sont des zones suffisamment étendues pour atteindre la photogrille de type MOS.

Selon un deuxième mode de réalisation, les moyens de séparation comprennent des murs comprenant une paroi électriquement conductrice débouchant sur la face d'hybridation de la plaque et se prolongeant à l'intérieur de la plaque en étant recouverte d'une couche de matériau électriquement isolant jusqu'à un sommet n'atteignant pas la face de réception d'une lumière, constituant ainsi avec le matériau semiconducteur de la plaque adjacent au mur une photogrille de type MOS, chaque photodétecteur comprenant une première zone dopée et une deuxième zone dopée, les premières zones dopées assurant les prises de contact électrique avec les plots de connexion des photodétecteurs, les deuxièmes zones dopées étant situées entre la face de réception d'une lumière et le sommet des murs et assurant des prises de contact électrique avec une première électrode commune située sur la face de réception d'une lumière, la face d'hybridation supportant une deuxième électrode commune reliant électriquement les parois électriquement conductrices des murs qui y débouchent.

Avantageusement, la matrice de photodétecteurs comprend des moyens de liaison électrique traversant la plaque de matériau semiconducteur pour relier la première électrode commune à une plage conductrice située sur la face d'hybridation.

Avantageusement, la première électrode commune comprend des conducteurs électriques possédant une forme permettant de réfléchir la lumière à détecter vers les parties de la face de réception dépourvues de conducteurs électriques. Cette forme des conducteurs électriques peut être une pointe dirigée vers la lumière à détecter.

Avantageusement, la deuxième électrode commune présente des parties situées en vis-à-vis de la plaque de matériau semiconducteur de surface adaptée pour permettre de réfléchir sur le matériau semiconducteur une fraction de lumière à détecter qui traverse la plaque de matériau semiconducteur.

Si le matériau semiconducteur est en silicium, la paroi électriquement conductrice peut être en polysilicium dopé et la couche de matériau électriquement isolant peut être en oxyde de silicium.

Selon une variante de réalisation, les premières zones dopées sont des zones suffisamment étendues pour atteindre la photogrille de type MOS.

Eventuellement, les zones dopées sont des zones à dopage multiple, de profondeur différente et de type identique ou complémentaire.

Selon encore un autre mode de réalisation, les murs comprenant une paroi électriquement conductrice sont alignés dans une première direction, des murs isolants étant alignés dans une deuxième direction qui est transversale à la première direction, les parois électriquement conductrices constituant des lignes de pilotage de photogrille indépendantes.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue en coupe transversale d'une matrice de photodétecteurs hybridée sur un circuit de lecture, selon un premier mode de réalisation de l'invention,
- la figure 2 est une vue de dessus de la figure 1 selon la coupe II-II,
- la figure 3 est une vue en coupe transversale d'une variante de réalisation d'une matrice de photodétecteurs hybridée sur un circuit de lecture, selon le premier mode de réalisation de l'invention,
- la figure 4 est une vue en coupe transversale d'une matrice de photodétecteurs hybridée sur un circuit de lecture, selon un deuxième mode de réalisation de l'invention,
- la figure 5 est une vue en coupe transversale d'une variante de réalisation d'une matrice de photodétecteurs hybridée sur un circuit de lecture, selon le deuxième mode de réalisation de l'invention,
- les figures 6A à 6N illustrent la réalisation d'une matrice de photodétecteurs hybridée sur un circuit de lecture selon le deuxième mode de réalisation de l'invention.

### DESCRIPTION DETAILLEE DE MODES DE REALISATION DE L'INVENTION

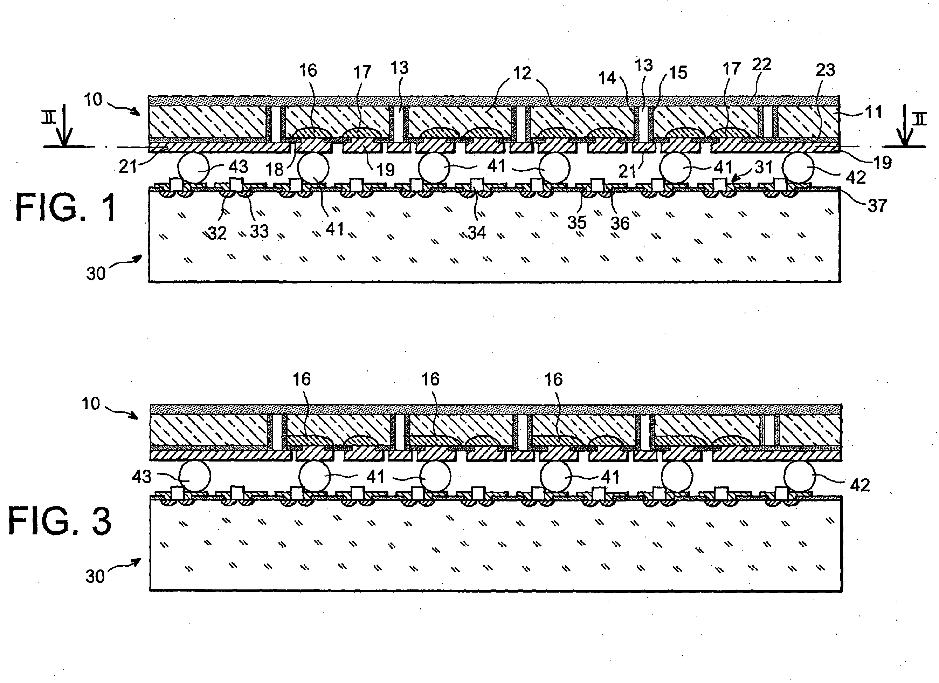

La figure 1 est une vue en coupe transversale d'une matrice de photodétecteurs hybridée sur un circuit de lecture, selon un premier mode de réalisation de l'invention.

La matrice de photodétecteurs 10 est constituée à partir d'une plaque de matériau semiconducteur 11 divisée en pixels ou photodétecteurs 12 par des murs disposés transversalement par rapport à la plaque 11 et selon toute son épaisseur. Les murs comprennent une paroi électriquement conductrice 13 prise en sandwich entre deux parois électriquement isolantes 14 et 15. Une paroi isolante prise entre le matériau semiconducteur et une paroi électriquement conductrice forme un condensateur MOS. Pour maximiser la valeur de la capacité du condensateur, l'épaisseur de l'isolant est choisie la plus fine possible tout en étant suffisante pour ne pas claquer sous les tensions appliquées.

Chaque pixel 12 comporte deux zones dopées complémentaires pour réaliser la prise de contact entre le métal et le semiconducteur et la collecte des charges. La zone dopée 16 assure la prise de contact avec le plot de connexion 18 du photodétecteur. La zone dopée 17 assure la prise de contact avec l'électrode 19 qui est une électrode commune pour tous les photodétecteurs.

Les parois conductrices 13 sont reliées électriquement, côté face d'hybridation, à une électrode 21 qui est une électrode commune pour l'ensemble des parois conductrices des murs.

La matrice de photodétecteurs 10 est recouverte, sur la face destinée à recevoir une lumière à détecter, d'une couche électriquement isolante et transparente 22. Elle est recouverte, sur sa face d'hybridation, d'une couche électriquement isolante 23 ouverte localement pour assurer les différentes liaisons électriques.

La figure 1 montre également un circuit de lecture 30 associé à la matrice de photodétecteurs 10. Le circuit de lecture 30 est réalisé sur un substrat en silicium. De manière connue, des amplificateurs et circuits de traitement CMOS 31 (ou bipolaire ou BiCMOS) ont été réalisés sur le substrat. A titre d'exemple, on reconnaît des zones de dopage P ou N 32 et 33, les grilles en polysilicium 34, des contacts de drain et de source 35 et 36 et une couche d'oxyde de silicium gravée 37.

L'hybridation de la matrice de photodétecteurs 10 sur le circuit de lecture 30 se fait au moyen de billes fusibles. Les plots de connexion 18 des photodétecteurs sont reliés au circuit de lecture par des billes 41. L'électrode commune 19 est reliée au circuit de lecture par des billes 42. L'électrode commune 21 est reliée au circuit de lecture par des billes 43.

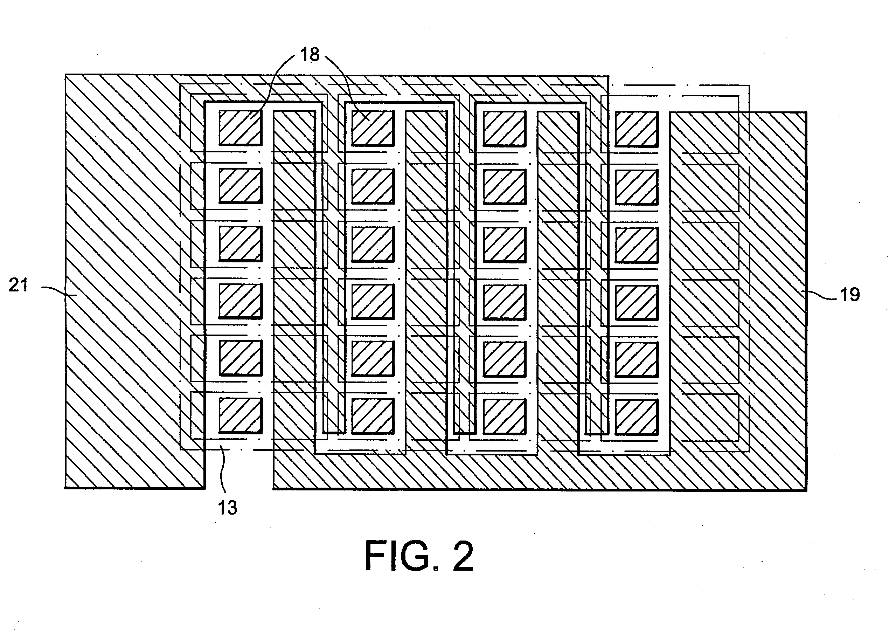

La figure 2 est une vue de dessus de la figure 1 selon la coupe II-II. Elle permet de montrer la disposition des différentes électrodes et plots de connexion sur la face d'hybridation de la matrice de photodétecteurs. On remarque que l'électrode commune 21 et l'électrode commune 19 forment des peignes interdigités. Les plots de connexion 18 forment des îlots. Les parois électriquement conductrices 13 des murs ont été représentées en traits mixtes.

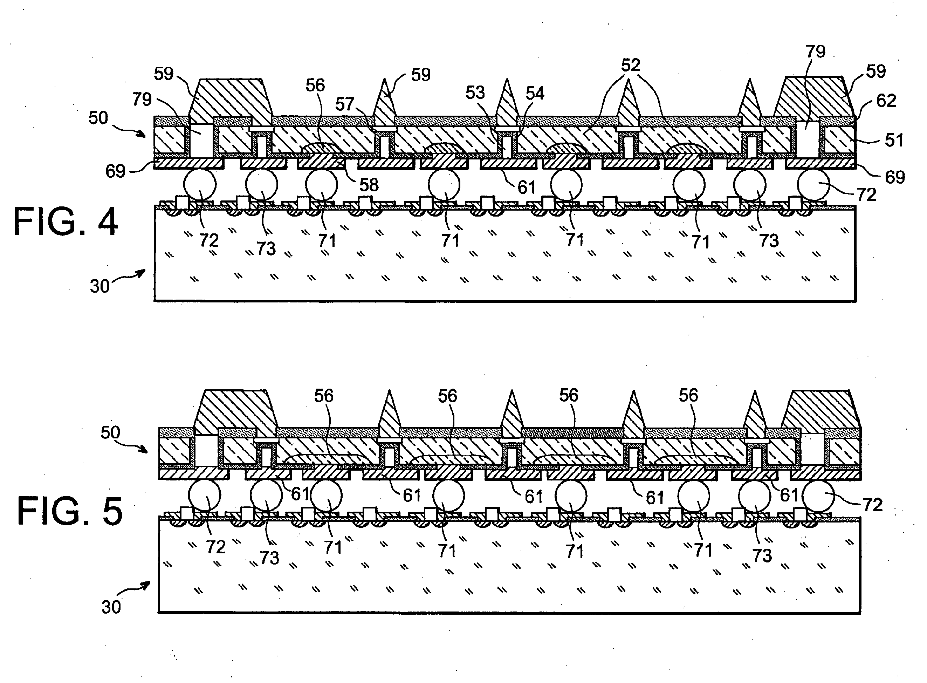

La figure 3 est une vue en coupe transversale d'une variante de réalisation d'une matrice de photodétecteurs sur un circuit de lecture, selon le premier mode de réalisation de l'invention. La matrice de photodétecteurs est pratiquement identique à celle représentée à la figure 1 à l'exception des zones dopées 16 qui sont les zones dopées correspondant aux plots de connexion des photodétecteurs. Ces zones dopées 16 sont telles que, pour chaque photodétecteur, la distance entre chaque zone dopée 16 et la zone de stockage des charges du condensateur est réduite. En fait, il y a extension de la zone dopée 16 le long des murs. Il existe une zone de recouvrement du condensateur MOS et de la zone dopée 16 comme cela est fait classiquement dans les transistors MOS.

La figure 4 est une vue en coupe transversale d'une matrice de photodétecteurs hybridée sur un circuit de lecture, selon un deuxième mode de réalisation de l'invention.

La matrice de photodétecteurs 50 est constituée à partir d'une plaque de matériau semiconducteur 51 divisée en pixels ou photodétecteurs 52 par des murs disposés transversalement par rapport à la plaque 51 et selon une partie de son épaisseur. Les murs comprennent une paroi électriquement conductrice 53 débouchant sur la face d'hybridation de la plaque 51 et recouverte d'une couche de matériau électriquement isolant 54 se prolongeant sur la face d'hybridation de la matrice de photodétecteurs. Le sommet du mur ainsi constitué laisse subsister une zone de matériau semiconducteur avant la face de réception de la lumière de la plaque 51. Ces murs forment un condensateur MOS.

La partie 57 de matériau semiconducteur comprise entre la couche isolante située sur le sommet des murs et la face de la plaque 51 destinée à recevoir la lumière à détecter est dopée et est en contact avec un conducteur électrique d'une première électrode commune 59. La séparation électrique des pixels est donc assurée. En effet, le dopage de cette partie 57, en contact avec le conducteur électrique 59, reliée à un potentiel de référence, interdit le passage de charges d'un pixel à l'autre.

Chaque pixel 52 comporte en son centre une zone dopée 56 de manière complémentaire par rapport à la zone dopée 57 et située côté face d'hybridation de la matrice de photodétecteurs. Les zones dopées 56 sont en contact électrique avec les plots de connexion correspondant 58.

La matrice de photodétecteurs 50 est recouverte, sur sa face destinée à recevoir une lumière à détecter, d'une couche électriquement isolante 62 ouverte localement pour assurer les différentes liaisons électriques. Elle est recouverte, sur sa face d'hybridation, du prolongement de la couche électriquement isolante 54 ouverte localement pour assurer les différentes liaisons électriques.

La face de la matrice de photodétecteurs destinée à recevoir la lumière à détecter supporte donc une première électrode commune 59. Les parties de cette première électrode commune 59 situées à gauche et à droite de la figure sont reliées électriquement à des plages de contact 69, situées sur la face d'hybridation de la matrice de photodétecteurs, par des traversées conductrices 79.

La première électrode commune 59 forme une grille étroite pour que le matériau semiconducteur de la matrice reçoive le maximum de lumière. Les conducteurs électriques de cette électrode sont de préférence taillés en pointe pour réfléchir la lumière incidente vers les parties non métallisées de la face de réception de la lumière.

Les parois conductrices 53 sont reliées électriquement, côté face d'hybridation, à une électrode 61 qui constitue la deuxième électrode commune. L'électrode 61 couvre le maximum de surface pour réfléchir vers le matériau semiconducteur la lumière qui n'aurait pas été absorbée.

La figure 4 montre également un circuit de lecture 30 associé à la matrice de photodétecteurs 50. Il est semblable à celui de la figure 1.

L'hybridation de la matrice de photodétecteurs 50 sur le circuit de lecture 30 se fait au moyen de billes fusibles. Les plots de connexion 58 des photodétecteurs sont reliés au circuit de lecture par des billes 71. La première électrode commune 59 est reliée au circuit de lecture par des billes 72 par l'intermédiaire des traversées conductrices 79 et des plages de contact 69. La deuxième électrode commune 61 est reliée au circuit de lecture par des billes 73.

La figure 5 est une vue en coupe transversale d'une variante de réalisation d'une matrice de photodétecteurs sur un circuit de lecture, selon le deuxième mode de réalisation de l'invention. La matrice de photodétecteurs est pratiquement identique à celle représentée à la figure 4 à l'exception des zones dopées 56 qui sont les zones dopées correspondant aux plots de connexion des photodétecteurs. Les zones dopées 56 ont été étendues pour venir rejoindre le condensateur. Il existe une zone de recouvrement entre les zones dopées 56 et la deuxième électrode commune 61.

La réduction de la distance électrique entre le condensateur et le plot de connexion permet un meilleur transfert des charges stockées dans le canal de la photopile. Dans le cas du dispositif de la figure 4, la zone de matériau semiconducteur restant entre le condensateur et la zone dopée 56 autorise la redistribution des charges stockées dans tout le pixel au moment de la permutation du potentiel de grille. Dans la variante représentée à la figure 5, la suppression de cette zone permet un passage rapide des charges directement de la grille au plot de connexion au moment de l'inversion du potentiel de grille. L'extension des zones dopées favorise la recombinaison des porteurs générés par la lumière et réduit donc le signal détecté. Suivant le type de signal lumineux à détecter, l'une ou l'autre variante, ou même un cas intermédiaire, sera préférée.

D'autres variantes sont possibles en remplaçant les zones à dopage unique 16, 17, 56 par des zones à plusieurs dopages de profondeur différente et de type identique ou complémentaire.

Les structures illustrées par les figures 1 à 5 sont des cas particuliers spécialement intéressants de la réalisation de photodétecteurs à photogrille et pixels isolés. Des variantes simples s'en déduisent facilement si l'on n'utilise qu'une partie des murs pour faire la capacité. En particulier, une structure où les murs dans une direction servent de capacité et les murs dans la direction perpendiculaire servent à prendre le contact des zones dopées reporté en surface éclairée. De même, les pixels décrits sont rectangulaires mais des pixels triangulaires ou hexagonaux, ou même des pixels de tailles variables sont envisageables, selon les contraintes de l'ensemble du système d'imagerie ou de mesure.

Une autre variante est le cas où les murs dans une direction servent de capacité et les murs dans l'autre direction sont isolants. Alors, chaque ligne ou chaque colonne de la photogrille peut être liée à une piste métallique différente et peut être pilotée indépendamment.

Les dimensions de la matrice de photodétecteurs sont variables selon les applications. A titre d'exemple, l'épaisseur de la plaque de matériau semiconducteur est de quelques µm à quelques dizaines de um. La largeur des pixels peut être voisine de l'épaisseur de la plaque. La hauteur des murs est voisine de l'épaisseur de la plaque ou inférieure à cette épaisseur. L'épaisseur de la couche isolante des murs est de l'ordre de 0,1 µm. Les zones dopées sont inférieures ou égales à la taille du pixel et peuvent être très fines (inférieures à 0,1 µm). Les matrices peuvent comprendre quelques dizaines à quelques millions de pixels.

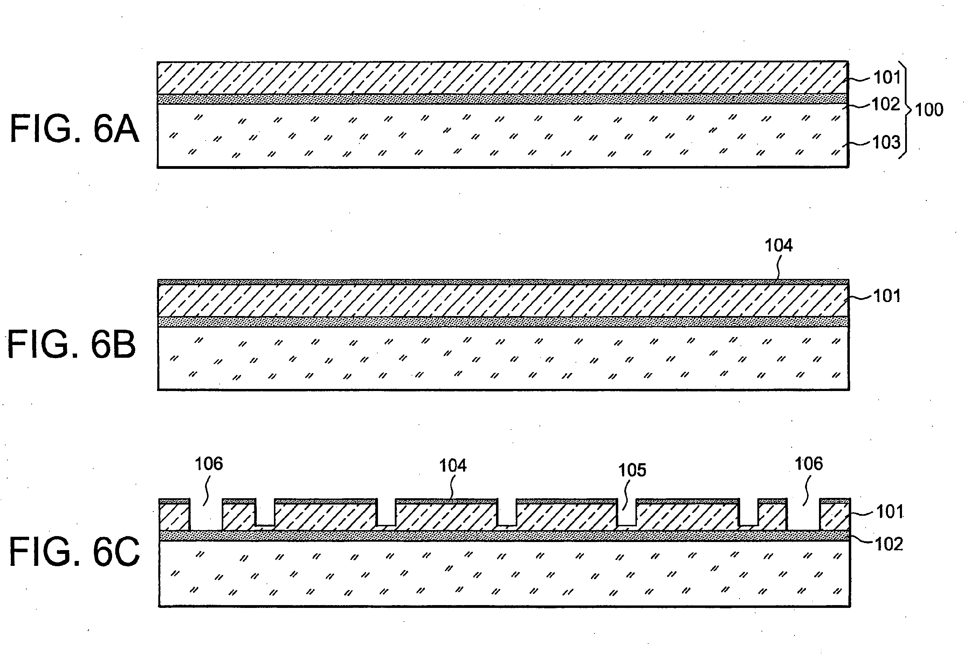

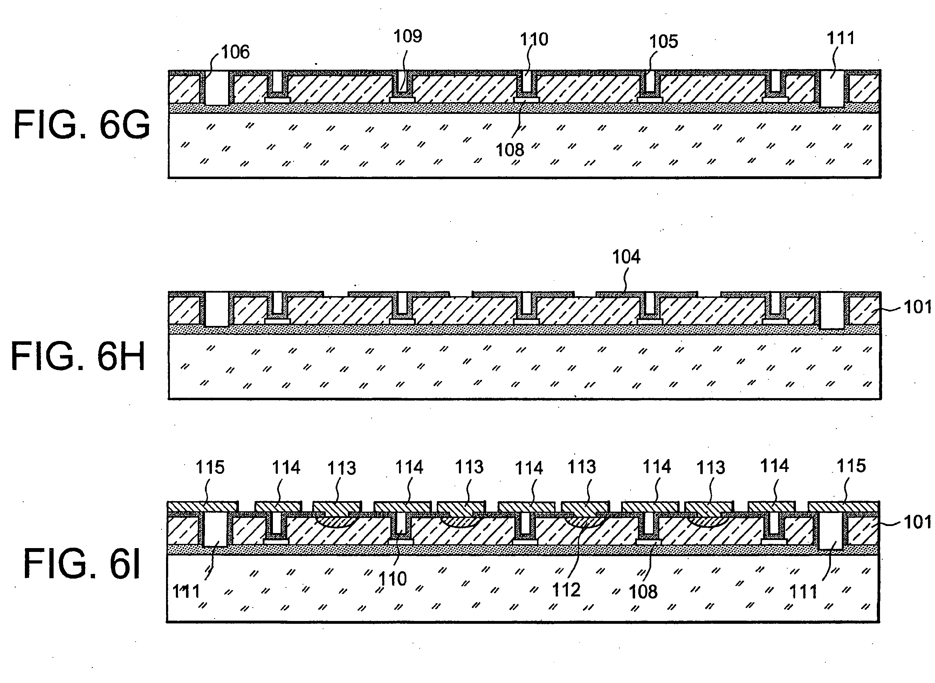

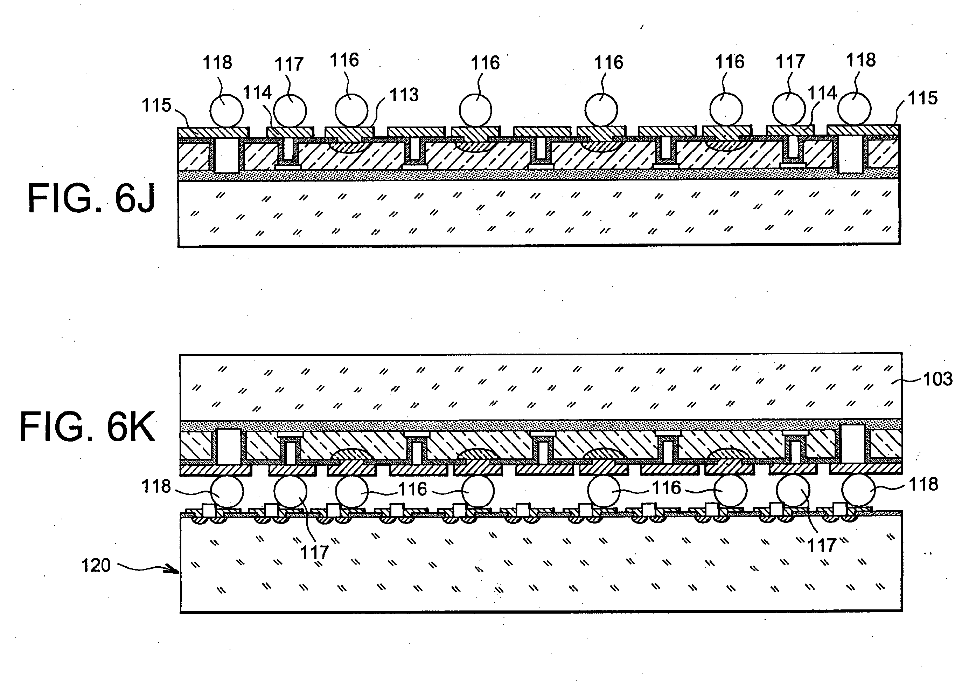

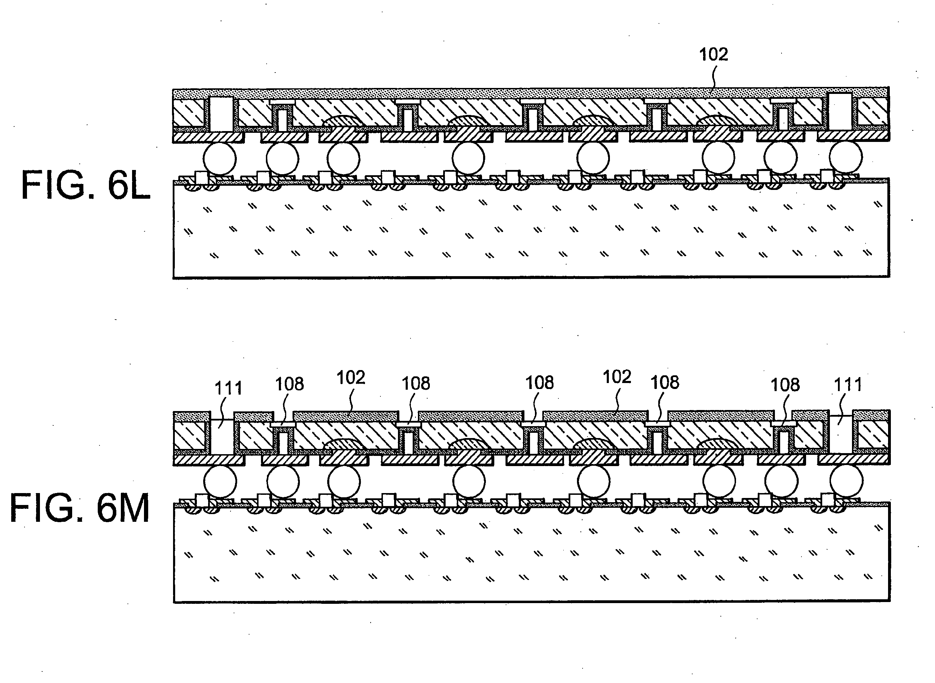

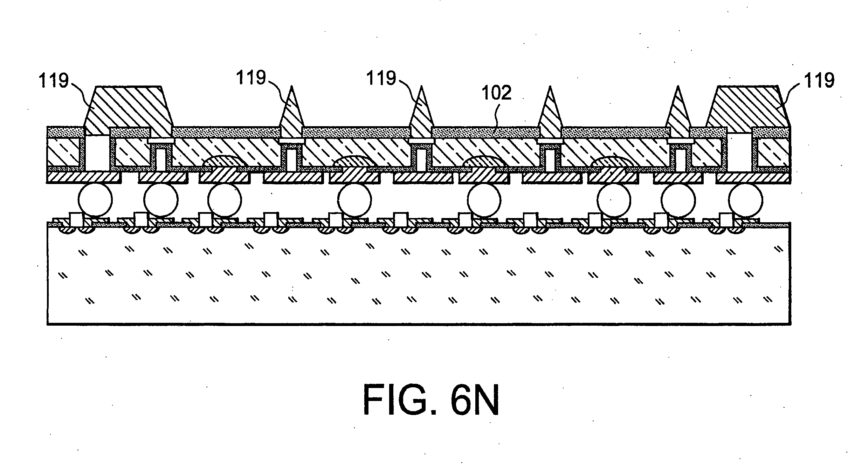

Les figures 6A à 6N illustrent la réalisation d'une matrice de photodétecteurs hybridée sur un circuit de lecture selon le deuxième mode de réalisation de l'invention. Les figures 6A à 6I illustrent la réalisation de la matrice de photodétecteurs uniquement. Les figures 6J à 6N illustrent l'hybridation de la matrice de photodétecteurs à son circuit de lecture. Toutes ces figures sont des vues en coupe transversale.

La figure 6A montre un substrat SOI 100 constitué d'un support en silicium 103 supportant successivement une couche d'oxyde de silicium 102 et une couche mince de silicium 101.

La couche mince de silicium 101 subit une étape d'oxydation pour obtenir une couche de passivation de surface et de protection 104 (voir la figure 6B). La couche 104 a une épaisseur de l'ordre de 0,5 µm.

Des tranchées sont ensuite réalisées dans la couche mince 101. Pour cela, une couche de résine est d'abord déposée sur la couche d'oxyde 104, puis est photolithographiée pour réaliser une gravure de la couche d'oxyde 104 aux emplacements prévus pour les tranchées. Après la gravure de la couche d'oxyde 104, la résine est retirée. Les tranchées sont ensuite gravées dans la couche mince de silicium 101. Les tranchées intérieures 105 sont de largeur plus restreinte que les tranchées extérieures 106. Il en résulte que les tranchées 105 n'atteignent pas la couche d'oxyde enterrée 102 tandis que les tranchées 106 atteignent la couche 102, la gravure étant plus rapide dans les gros motifs que dans les petits. C'est ce que montre la figure 6C.

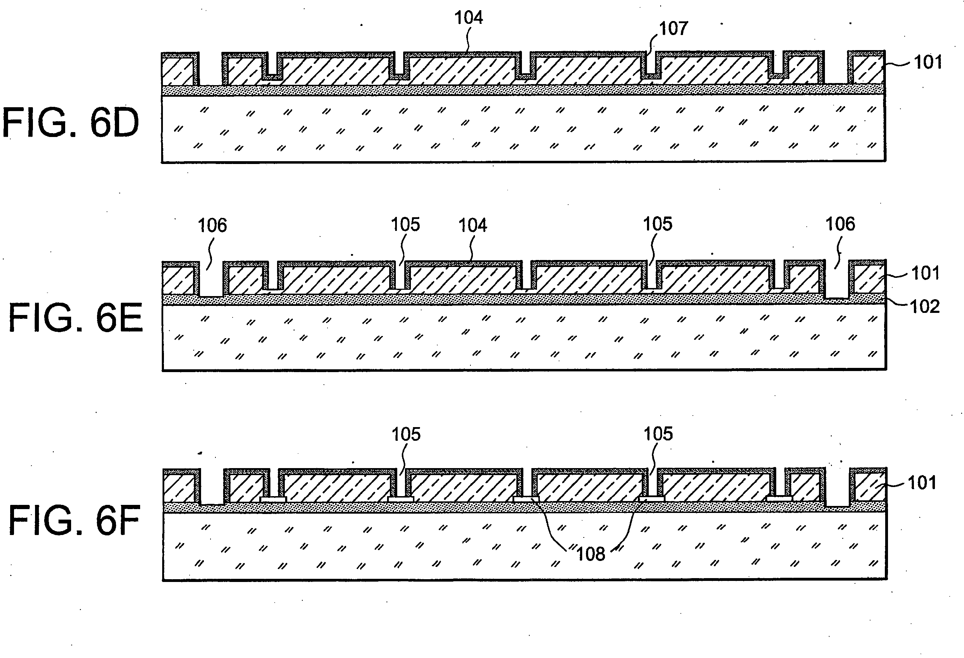

On procède ensuite à une oxydation de surface des parties de silicium apparentes pour obtenir une couche continue d'isolation de surface 104-107 de la couche mince de silicium 101. C'est ce que montre la figure 6D.

On procède ensuite à une gravure anisotrope de l'oxyde pour éliminer la couche d'oxyde présente au fond des tranchées 105 et exposer le matériau semiconducteur 101 au fond de ces tranchées. Par contre, la couche d'oxyde initiale 104 sur la couche mince de silicium 101 et la couche d'oxyde enterrée 102 possèdent encore une épaisseur suffisante. C'est ce que montre la figure 6E.

Des dopants sont ensuite implantés dans les parties exposées de la couche mince de matériau semiconducteur 101, au fond des tranchées 105. On procède ensuite à la diffusion des dopants grâce à un recuit pour obtenir les zones dopées 108 comme le montre la figure 6F.

La figure 6G montre la structure obtenue après les opérations suivantes :
- oxydation de surface pour obtenir une couche d'isolation 109 sur les zones dopées 108,
- remplissage des tranchées 105 et 106 par un matériau conducteur, par exemple du polysilicium,
- élimination du surplus de remplissage par polissage mécano-chimique pour obtenir des parois électriquement conductrices 110 et des traversées conductrices 111.

Une couche de résine est ensuite déposée sur la couche d'oxyde 104. Par photolithographie de la résine, la couche d'oxyde 104 est gravée pour exposer localement la couche mince de matériau semiconducteur 101. C'est ce que montre la figure 6H.

Des dopants complémentaires aux dopants des zones 108 sont implantés dans les parties exposées de la couche mince 101 pour obtenir des zones dopées 112 (voir la figure 6I). La résine restante est retirée. Une couche métallique est ensuite uniformément déposée. Une couche de résine est déposée sur cette couche métallique. Par photolithographie, on procède à la gravure de la couche métallique et la résine est retirée. On obtient en surface des plots de connexion 113 reliant électriquement les zones dopées 112, une électrode commune 114 connectée électriquement aux parois conductrices 110 et des plages de contact 115 connectées aux traversées conductrices 111.

La figure 6J montre la structure obtenue après la formation des billes conductrices 116 sur les plots de connexion 113, des billes conductrices 117 sur l'électrode commune 114 et des billes conductrices 118 sur les plages de contact 115. Une autre façon de faire est de former les billes fusibles sur le circuit de lecture.

La figure 6K montre le résultat de l'hybridation par "flip chip" de la matrice de photodétecteurs sur un circuit de lecture 120 au moyen des billes fusibles 116, 117 et 118. Un remplissage au moyen d'un matériau isolant peut être réalisé entre la matrice de photodétecteurs et le circuit de lecture.

On procède ensuite à l'élimination du support 103 du substrat SOI initial. Cette élimination peut être réalisée par polissage et/ou gravure avec arrêt sur la couche d'oxyde 102 comme le montre la figure 6L.

Une couche de résine est ensuite déposée sur la couche d'oxyde 102. Par photolithographie, on procède à la gravure de la couche d'oxyde 102 pour exposer les traversées conductrices 111 et les zones implantées 108. La résine est retirée. On obtient la structure représentée à la figure 6M.

Une couche métallique est déposée sur la couche d'oxyde gravée 102. Une couche de résine est déposée sur la couche métallique. Par photolithographie, on procède à la gravure de la couche métallique avec maîtrise de la pente des gravures. La résine est retirée et l'on obtient la structure représentée à la figure 6N comportant l'électrode commune 119 sur la face de réception de la lumière à détecter.

D'autres étapes peuvent suivre, par exemple une étape de découpe des structures en puces à l'issue d'un procédé collectif. Avant cette étape de découpe, d'autres étapes peuvent être ajoutées pour créer des filtres ou des couches antireflet. L'ordre des étapes n'est pas obligatoirement celui indiqué ci-dessus.

La matrice de photodétecteurs selon l'invention possède une grille capacitive. La particularité de cette capacité de stockage de charges est de permettre un fonctionnement plus performant de la détection. Elle assure l'accumulation des charges et permet leur transfert simultané vers les amplificateurs. Son positionnement sur les parois des pixels permet d'obtenir une grande capacité sans prendre de place dans la structure. La paroi des pixels isolés représente une surface importante, souvent supérieure à la surface éclairée du pixel et favorable à un large stockage. Il n'y a pas d'augmentation de la taille des pixels. Tous les avantages connus sur les autres structures de l'art antérieur sont conservés :
- toute la surface de la matrice contribue à la collecte de la lumière,
- les pixels sont isolés électriquement les uns des autres et ne peuvent pas échanger leurs charges,
- les résistances d'interconnexions sont minimales,
- l'hybridation sur un circuit amplificateur est conservée,
- le nombre de connexions avec le circuit amplificateur est minimum,
- la taille des zones dopées est ajustable selon le signal optique à détecter,
- les pertes de lumière sont minimisées par réflexion sur les faces avant et arrière des métallisations conductrices,
- tous les contacts de sortie des signaux vers l'extérieur, peuvent être pris sur la face supérieure de la matrice en bord de zone éclairée,
- l'ajout de composants optiques tel que couche antireflet ou filtre optique ou concentrateur de lumière est toujours possible.

## Revendications

1. Matrice de photodétecteurs (10, 50) destinée à être hybridée sur un circuit de lecture et constituée à partir d'une plaque de matériau semiconducteur (11, 51) présentant une face de réception d'une lumière à détecter et une face opposée dite face d'hybridation, **caractérisée en ce que** la plaque est divisée en pixels (12, 52), chaque pixel constituant un photodétecteur, les pixels étant séparés les uns des autres par des moyens de séparation formés transversalement dans la plaque et les moyens de séparation comprenant une photogrille pour les photodétecteurs, chaque photodétecteur présentant, sur la face d'hybridation, un plot de connexion (18, 58) permettant d'hybrider la matrice de photodétecteurs au circuit de lecture.

2. Matrice de photodétecteurs selon la revendication 1, **caractérisée en ce que** les moyens de séparation comprennent des murs comprenant une paroi électriquement conductrice (13) prise en sandwich entre des parois électriquement isolantes (14, 15), constituant ainsi avec le matériau semiconducteur de la plaque (11) adjacent au mur une photogrille de type MOS, chaque photodétecteur comprenant une première zone dopée (16) et une deuxième zone dopée (17), les premières zones dopées (16) assurant les prises de contact électrique avec les plots de connexion (18) des photodétecteurs, les deuxièmes zones dopées (17) assurant les prises de contact électrique avec une première électrode commune (19), dite électrode de base commune des pixels, située sur la face d'hybridation, les parois électriquement conductrices des murs (13) étant reliées à une deuxième électrode commune (21) située sur la face d'hybridation.

3. Matrice de photodétecteurs selon la revendication 2, **caractérisée en ce que** la première électrode commune (19) et la deuxième électrode commune (21) forment des peignes interdigités.

4. Matrice de photodétecteurs selon l'une des revendications 2 ou 3, **caractérisée en ce que** le matériau semiconducteur est en silicium, la paroi électriquement conductrice (13) des murs est en polysilicium dopé et les parois électriquement isolantes (14, 15) des murs sont en oxyde de silicium.

5. Matrice de photodétecteurs selon l'une quelconque des revendications 2 à 4, **caractérisée en ce que** les premières zones dopées (16) sont des zones suffisamment étendues pour atteindre la photogrille de type MOS.

6. Matrice de photodétecteurs selon la revendication 1, **caractérisée en ce que** les moyens de séparation comprennent des murs comprenant une paroi électriquement conductrice (53) débouchant sur la face d'hybridation de la plaque (51) et se prolongeant à l'intérieur de la plaque en étant recouverte d'une couche de matériau électriquement isolant (54) jusqu'à un sommet n'atteignant pas la face de réception d'une lumière, constituant ainsi avec le matériau semiconducteur de la plaque adjacent au mur photogrille de type MOS, chaque photodétecteur (52) comprenant une première zone dopée (56) et une deuxième zone dopée (57), les premières zones dopées (56) assurant les prises de contact électrique avec les plots de connexion (71) des photodétecteurs, les deuxièmes zones dopées (57) étant situées entre la face de réception d'une lumière et le sommet des murs et assurant des prises de contact électrique avec une première électrode commune (59) située sur la face de réception d'une lumière, la face d'hybridation supportant une deuxième électrode commune (61) reliant électriquement les parois électriquement conductrices des murs qui y débouchent.

7. Matrice de photodétecteurs selon la revendication 6, **caractérisée en ce qu'**elle comprend des moyens de liaison électrique (79) traversant la plaque de matériau semiconducteur pour relier la première électrode commune (59) à une plage conductrice (69) située sur la face d'hybridation.

8. Matrice de photodétecteurs selon l'une des revendications 6 ou 7, **caractérisée en ce que** la première électrode commune (59) comprend des conducteurs électriques possédant une forme permettant de réfléchir la lumière à détecter vers les parties de la face de réception dépourvues de conducteurs électriques.

9. Matrice de photodétecteurs selon la revendication 8, **caractérisée en ce que** ladite forme des conducteurs électriques est une pointe dirigée vers la lumière à détecter.

10. Matrice de photodétecteurs selon l'une quelconque des revendications 6 à 9, **caractérisée en ce que** la deuxième électrode commune (61) présente des parties situées en vis-à-vis de la plaque de matériau semiconducteur (51) de surface adaptée pour permettre de réfléchir sur le matériau semiconducteur une fraction de lumière à détecter qui traverse la plaque de matériau semiconducteur.

11. Matrice de photodétecteurs selon l'une quelconque des revendications 6 à 10, **caractérisée en ce que** le matériau semiconducteur est en silicium, la paroi électriquement conductrice (53) est en polysilicium dopé et la couche de matériau électriquement isolant (54) est en oxyde de silicium.

12. Matrice de photodétecteurs selon l'une quelconque des revendications 6 à 11, **caractérisée en ce que** les premières zones dopées (56) sont des zones suffisamment étendues pour atteindre la photogrille de type MOS.

13. Matrice de photodétecteurs selon l'une quelconque des revendications 2 à 12, **caractérisée en ce que** les zones dopées sont des zones à dopage multiple, de profondeur différente et de type identique ou complémentaire.

14. Matrice de photodétecteurs selon l'une quelconque des revendications 2 à 13, **caractérisée en ce que** les murs comprenant une paroi électriquement conductrice sont alignés dans une première direction, des murs isolants étant alignés dans une deuxième direction qui est transversale à la première direction, les parois électriquement conductrices constituant des lignes de pilotage de photogrille indépendantes.

## Claims

1. Photodetector array (10, 50) that will be hybridized on a readout circuit and realized from a wafer of semiconducting material (11, 51) with one light reception face to be detected and one opposite face called the hybridizing face, **characterized in that** the wafer is divided into pixels (12, 52), each pixel forming a photodetector, the pixels being separated from each other by separation means formed transversely in the wafer and the separation means comprising a photogrid for photodetectors, each photodetector having a connection pad (18, 58) on the hybridizing face to hybridize the photodetector array to the readout circuit.

2. Photodetector array according to claim 1, **characterized in that** the separation means comprise walls comprising an electrically conducting skin (13) sandwiched between electrically insulating skins (14, 15), thus forming a MOS type photogrid with the semiconducting material in the wafer (11) adjacent to the wall, each photodetector comprising a first doped area (16) and a second doped area (17), the first doped areas (16) forming electrical contacts with photodetector connection pads (18), the second doped areas (17) forming electrical contacts with a first common electrode (19) called the pixels common base electrode located on the hybridizing face, the electrically conducting skins of the walls (13) being connected to a second common electrode (21) located on the hybridizing face.

3. Photodetector array according to claim 2, **characterized in that** the first common electrode (19) and the second common electrode (21) form interdigitized combs.

4. Photodetector array according to either claim 2 or 3, **characterized in that** if the semiconducting material is made of silicon, the electrically conducting skin (13) of the walls is made of doped polysilicon and the electrically insulating skins (14, 15) of the walls are made of silicon oxide.

5. Photodetector array according to any one of claims 2 to 4, **characterized in that** the first doped areas (16) are sufficiently large to reach the MOS type photogrid.

6. Photodetector array according to claim 1, **characterized in that** the separation means comprise walls comprising an electrically conducting skin (53) opening onto the hybridizing face of the wafer (51) and being prolonged inside the wafer being covered with a layer of electrically insulating material (54) as far as a top that does not reach the light reception face, thus forming a MOS type photogrid with the semiconducting material in the wafer adjacent to the wall, each photodetector (52) comprising a first doped area (56) and a second doped area (57), the first doped areas (56) forming electrical contact areas with photodetector connection pads (71), the second doped areas (57) being located between the light reception face and the top of the walls, forming electrical contact areas with a first common electrode (59) located on the light reception face, the hybridizing face supporting a second common electrode (61) electrically connecting the electrically conducting skins of walls that lead into it.

7. Photodetector array according to claim 6, **characterized in that** the photodetector array comprises electrical connection means (79) passing through the wafer of semiconducting material to connect the first common electrode (59) to a conducting strip (69) located on the hybridizing face.

8. Photodetector array according to either of claim 6 or 7, **characterized in that** the first common electrode (59) comprises electrical conductors with a shape capable of reflecting light to be detected towards the parts of the reception face without electrical conductors.

9. Photodetector array according to claim 8, **characterized in that** said shape of the electrical conductors is a tip directed towards the light to be detected.

10. Photodetector array according to any ane of claims 6 to 9, **characterized in that** the second common electrode (61) has parts facing the wafer of semiconducting material (51) with an area making it possible to reflect a fraction of the light to be detected that passes through the wafer of semiconducting material, onto the semiconducting material.

11. Photodetector array according to any one of claims 6 to 10, **characterized in that** the semiconducting material is made of silicon, the electrically conducting skin (53) is made of doped polysilicon and the layer of electrically insulating material (54) is made of silicon oxide.

12. Photodetector array according to any one of claims 6 to 11, **characterized in that** the first doped areas (56) are sufficiently extended to reach the MOS type photogrid.

13. Photodetector array according to any one of claims 2 to 12, **characterized in that** the doped areas are multiple doped areas with a different depth and an identical or complementary type.

14. Photodetector array according to any one of claims 2 to 13, **characterized in that** the walls comprising an electrically conducting skin are aligned in a first direction, the insulating walls being aligned in a second direction transverse to the first direction, the electrically conducting skins forming independent photogrid control lines.

## Patentansprüche

1. Photodetektorenanordnung (10, 50), dazu bestimmt, hybrid auf eine Leseschaltung montiert zu werden, die gebildet wird durch eine Platte aus Halbleitermaterial (11, 51) mit einer Empfangsseite eines zu detektierenden Lichts und einer entgegengesetzten Seite, Hybridisierungsseite genannt,
**dadurch gekennzeichnet, dass** die Platte in Pixel (12, 52) aufgeteilt ist, wobei jedes Pixel einen Photodetektor bildet und die Pixel voneinander getrennt sind durch transversal in der Platte ausgebildete Trenneinrichtungen und diese Trenneinrichtungen ein Photogitter für die Photodetektoren umfassen, wobei jeder Photodetektor auf seiner Hybridisierungsseite ein Verbindungselement (18, 58) umfasst, das die Hybridmontage der Photodetektorenanordnung auf die Leseschaltung ermöglicht.

2. Photodetektorenanordnung nach Anspruch 1, **dadurch gekennzeichnet, dass** die Trenneinrichtungen Mauern umfassen, sandwichartig gebildet durch eine elektrisch leitende Wand (13) zwischen elektrisch isolierenden Wänden (14, 15), die mit dem Halbleitermaterial der an die Mauer angrenzenden Platte (11) ein Photogitter des Typs MOS bilden, wobei jeder Photodetektor eine erste dotierte Zone (16) und eine zweite dotierte Zone (17) umfasst, die ersten dotierten Zonen (16) die elektrischen Kontakte mit den Verbindungselementen (18) der Photodetektoren gewährleisten und die zweiten dotierten Zonen (17) die elektrischen Kontakte mit einer ersten gemeinsamen Elektrode (19) gewährleisten, Gemeinschaftsbasiselektrode der Pixel genannt und auf der Hybridisierungsseite befindlich, wobei die elektrisch leitenden Wände der Mauern (13) mit einer gemeinsamen Elektrode (21) verbunden sind, die sich auf der Hybridisierungsseite befindet.

3. Photodetektorenanordnung nach Anspruch 2, **dadurch gekennzeichnet, dass** die erste gemeinsame Elektrode (19) und die zweite gemeinsame Elektrode (21) wie Kämme ineinander stecken.

4. Photodetektorenanordnung nach einem der Ansprüche 2 oder 3, **dadurch gekennzeichnet, dass** das Halbleitermaterial aus Silicium ist, die elektrisch isolierende Wand (13) der Mauern aus dotiertem Polysilicium ist und die elektrisch isolierenden Wände (14, 15) der Mauern aus Siliciumoxid sind.

5. Photodetektorenanordnung nach einem der Ansprüche 2 bis 4, **dadurch gekennzeichnet, dass** die ersten dotierten Zonen (16) ausreichend große Zonen sind, um das Photogitter des Typs MOS zu erreichen.

6. Photodetektorenanordnung nach Anspruch 1, **dadurch gekennzeichnet, dass** die Trenneinrichtungen Mauern mit einer elektrisch leitenden Wand (53) umfassen, die sich von der Hybridisierungsseite der Platte (51) aus ins Innere der Platte erstreckt und bis zu einem oberen Teil, der die Empfangsfläche eines Lichts nicht erreicht, mit einer Schicht (54) aus einem elektrisch isolierenden Material überzogen ist, und die auf diese Weise mit dem Halbleitermaterial der an die Mauer angrenzenden Platte ein Photogitter des Typs MOS bildet, wobei jeder Photodetektor (52) eine erste dotierte Zone (56) und eine zweite dotierte Zone (57) umfasst, die ersten dotierten Zonen (56) die elektrischen Kontakte mit den Verbindungselementen (71) der Photodetektoren gewährleisten und die zweiten dotierten Zonen (57) sich zwischen der Empfangsfläche eines Lichts und dem Oberteil der Mauern befinden und elektrische Kontakte mit einer ersten gemeinsamen Elektrode (59) gewährleisten, die sich auf der Empfangsfläche eines Lichts befindet, wobei die Hybridisierungsseite eine zweite gemeinsame Elektrode (61) trägt, welche die elektrisch leitenden Wände der Mauern verbindet, die hier austreten.

7. Photodetektorenanordnung nach Anspruch 6, **dadurch gekennzeichnet, dass** sie elektrische Verbindungseinrichtungen (79) umfasst, welche die Platte aus Halbleitermaterial durchqueren, um die erste gemeinsame Elektrode (59) und einen leitfähigen Bereich (69) zu verbinden, der sich auf der Hybridisierungsseite befindet.

8. Photodetektorenanordnung nach einem der Ansprüche 6 oder 7, **dadurch gekennzeichnet, dass** die erste gemeinsame Elektrode (59) elektrische Leiter umfasst, die eine Form besitzen, die ermöglicht, das zu detektierende Licht auf die Teile der Empfangsfläche ohne elektrische Leiter zu reflektieren.

9. Photodetektorenanordnung nach Anspruch 8, **dadurch gekennzeichnet, dass** die genannte Form der elektrischen Leiter eine dem zu detektierenden Licht entgegengerichtete Spitze ist.

10. Photodetektorenanordnung nach einem der Ansprüche 6 bis 9, **dadurch gekennzeichnet, dass** die zweite gemeinsame Elektrode (61) der Halbleitermaterialplatte (51) gegenüber Abschnitte aufweist, deren Oberfläche so beschaffen ist, dass sie einen Teil des zu detektierenden Lichts, das die Halbleitermaterialplatte durchquert, in das Halbleitermaterial reflektiert.

11. Photodetektorenanordnung nach einem der Ansprüche 6 bis 10, **dadurch gekennzeichnet, dass** das Halbleitermaterial aus Silicium ist, die elektrisch leitende Wand (53) ein dotiertes Polysilicium ist und die Schicht aus elektrisch isolierendem Material (54) aus Siliciumoxid ist.

12. Photodetektorenanordnung nach einem der Ansprüche 6 bis 11, **dadurch gekennzeichnet, dass** die ersten dotierten Zonen (56) ausreichend große Zonen sind, um das Photogitter des Typs MOS zu erreichen.

13. Photodetektorenanordnung nach einem der Ansprüche 2 bis 12, **dadurch gekennzeichnet, dass** die dotierten Zonen Zonen mit mehreren Dotierungen unterschiedlicher Tiefe und identischen oder komplementären Typs sind.

14. Photodetektorenanordnung nach einem der Ansprüche 2 bis 13, **dadurch gekennzeichnet, dass** die eine elektrisch leitende Wand umfassenden Mauern in einer ersten Richtung fluchten, wobei isolierende Mauern in einer zu ersten Richtung transversalen zweiten Richtung fluchten und die elektrisch leitenden Mauern unabhängige Photogitter-Steuerungszeilen bilden.
